(19) **Europäisches Patentamt / European Patent Office / Office européen des brevets**

(11) **EP 4 016 091 B1**

(12) **FASCICULE DE BREVET EUROPEEN**

(45) Date de publication et mention de la délivrance du brevet:
**28.08.2024 Bulletin 2024/35**

(21) Numéro de dépôt: **21213098.3**

(22) Date de dépôt: **08.12.2021**

(51) Classification Internationale des Brevets (IPC):
**G01R 19/165** *(2006.01)* **G01R 19/00** *(2006.01)*

(52) Classification Coopérative des Brevets (CPC):
**G01R 19/16547; G01R 19/00; G01R 19/16523**

(54) **DISPOSITIF ONDULEUR COMPRENANT UN DISPOSITIF DE MESURE DE TENSION**

WECHSELRICHTERVORRICHTUNG MIT EINER SPANNUNGSMESSVORRICHTUNG

INVERTER DEVICE COMPRISING A VOLTAGE METERING DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.12.2020 FR 2013299**

(43) Date de publication de la demande:
**22.06.2022 Bulletin 2022/25**

(73) Titulaire: **Safran Electrical & Power**
**31700 Blagnac (FR)**

(72) Inventeur: **ABDESSELAM, Francis**
**78400 CHATOU (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**US-A1- 2009 243 431 US-A1- 2012 068 548**
**US-A1- 2017 097 381 US-A1- 2020 052 586**

**Description**

L'invention se situe dans le domaine de la mesure de courants et de tensions.

Elle trouve notamment son application dans la régulation de tensions au moyen d'interrupteurs de puissance.

Elle trouve, par exemple, son application dans la commande d'un onduleur de tension pour réguler la tension de sortie de l'onduleur, par exemple, par modulation par largeur d'impulsions ou MLI par hystérésis.

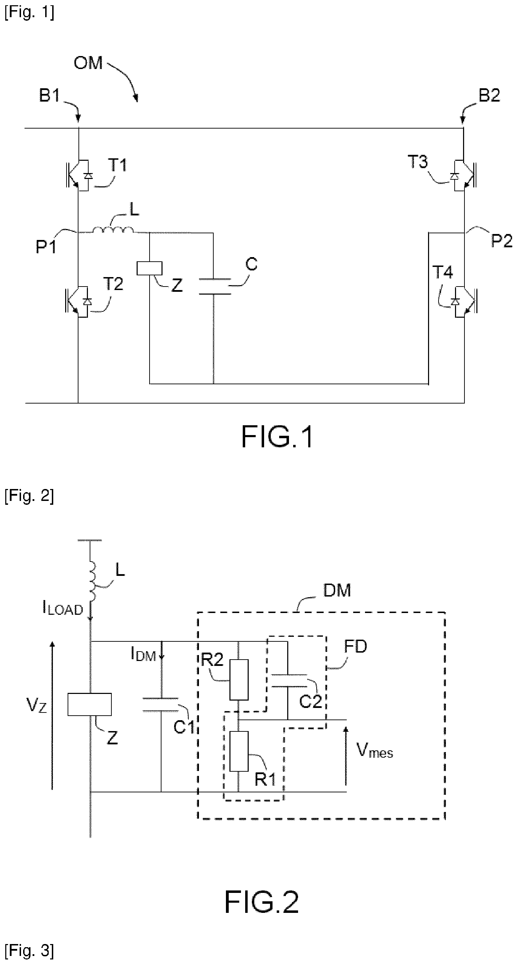

Un exemple d'onduleur OM est représenté en figure 1. Cet onduleur OM comprend quatre interrupteurs de puissance commandables T1, T2, T3, T4 montés en pont en H. Le pont en H comprend deux branches B1 et B2 comprenant chacune deux interrupteurs connectés en série. La première branche B1 comprend un premier interrupteur T1 et un deuxième interrupteur T2 reliés en série par l'intermédiaire d'un premier point P1 dit premier point milieu. La deuxième branche B2 comprend un troisième interrupteur T3 et un quatrième interrupteur T4 reliés en série par l'intermédiaire d'un deuxième point P2 dit deuxième point milieu. L'onduleur OM est muni d'un filtre passe-bas de sortie reliant entre eux les points milieu P1 et P2. Le filtre de sortie comprend une inductance de sortie L montée en série avec un condensateur C. D'autres exemples de circuits en pont (ou demi-pont) sont proposés dans le document US 2012/068548 A1.

Lorsque l'on commande l'onduleur pour que la tension d'alimentation d'une charge Z montée en parallèle avec le condensateur C soit la tension sinusoïdale de référence, la tension aux bornes du condensateur C est une sinusoïde basse fréquence et le courant circulant dans le condensateur C un courant est un triangulaire dont la fréquence est la fréquence de commutation des interrupteurs qui est élevée comparée à celle de la tension.

Afin de réguler la tension délivrée par l'onduleur OM, c'est-à-dire de commander les interrupteurs de puissance de l'onduleur OM pour qu'il alimente la charge Z par une tension sinusoïdale de référence, il est nécessaire de disposer d'une mesure correspondant à une somme pondérée de la tension aux bornes du condensateur et d'une tension image du courant circulant dans le condensateur, comme proposé dans le document US 2009/243431 A1.

De façon classique, la tension de sortie délivrée par l'onduleur OM est mesurée par des moyens de mesure de la tension, par exemple, au moyen de résistances, et le courant est mesuré par un transformateur d'intensité constitué d'un enroulement primaire, d'un enroulement secondaire, d'un circuit magnétique et d'une charge basse impédance en série avec l'enroulement secondaire permettant de mesurer le courant circulant dans le primaire avec un rapport de transformation. Les mesures de courant et de tension sont ensuite sommées de façon pondérée au travers d'un amplificateur sommateur.

Un but de la présente invention est de proposer une solution simplifiée.

A cet effet, l'invention a pour objet un dispositif onduleur selon la revendication indépendante 1. D'autres modes de réalisation sont définis dans les revendications dépendantes.

D'autres caractéristiques, détails et avantages de l'invention ressortiront à la lecture de la description faite en référence aux dessins annexés donnés à titre d'exemple et qui représentent, respectivement :

[Fig.1], la figure 1 est une illustration d'un onduleur muni d'un filtre de sortie et alimentant une charge,

[Fig.2], la figure 2 est une illustration d'un dispositif de mesure selon l'invention,

[Fig.3], la figure 3 est une illustration d'une mesure issue d'un dispositif de mesure selon l'invention,

[Fig.4], la figure 4 est une illustration d'un dispositif onduleur selon l'invention comprenant un onduleur et un dispositif de mesure selon l'invention.

D'une figure à l'autre, les mêmes éléments sont repérés par les mêmes références.

L'invention se rapporte à un dispositif de mesure permettant de délivrer une tension correspondant à une superposition d'une tension appliquée à ses bornes et d'une tension image d'un courant alimentant un premier condensateur.

Ce dispositif de mesure permet, notamment, de délivrer une tension correspondant à une somme pondérée d'une tension sinusoïdale appliquée à ses bornes et d'une tension image d'un courant alternatif, par exemple triangulaire, alimentant le premier condensateur et étant de fréquence très élevée par rapport à la fréquence de la tension appliquée aux bornes du dispositif de mesure, c'est-à-dire supérieure au décuple de la fréquence de la tension appliquée à ses bornes.

Par tension image d'un courant, on entend une tension présentant les mêmes forme, phase et fréquence que le courant.

Ce dispositif de mesure trouve son utilité dans la fourniture d'une mesure utilisée pour réguler une tension de forme et de fréquence quelconques au moyen d'interrupteurs de puissance.

Ce dispositif de mesure trouve, par exemple, son utilité dans la fourniture d'une commande pour commander les d'interrupteurs de puissance d'un onduleur de tension de sorte à réguler la tension délivrée par cet onduleur aux bornes du premier condensateur sur une tension sinusoïdale de référence, par exemple par MLI à hystérésis.

Le dispositif de mesure DM selon l'invention est représenté en figure 2. Sur cette figure, le dispositif de mesure DM est monté en parallèle avec une impédance utilisateur Z de valeur d'impédance z pouvant, par exemple, être selfique, capacitive ou résistive alimentée par une tension $V_z$, par exemple une tension de sortie d'un onduleur.

Le dispositif de mesure est monté en parallèle avec le premier condensateur C1 de première capacité c1.

Le premier condensateur est relié à une inductance L. Le condensateur et l'inductance forment un circuit LC appelé LC1 dans la suite du texte.

Le courant $I_{DM}$ est la partie alternative du courant $I_{LOAD}$ circulant dans l'inductance.

Avantageusement, la première capacité c1 est telle que le produit de la valeur de l'inductance L et de la première capacité c1 est inférieur au décuple d'une période $T_{AC}$ maximale de la partie alternative du courant destiné à circuler dans le premier condensateur C1, c'est-à-dire de la période $T_{AC}$ maximale du courant destiné à circuler dans le premier condensateur C1.

Autrement dit, la fréquence minimale de la partie alternative du courant destiné à circuler dans l'inductance L est très supérieure à la fréquence de résonnance du circuit LC1 ce qui permet d'obtenir un courant de faible amplitude dans le condensateur C1.

Le dispositif de mesure DM comprend un filtre dérivateur FD monté en parallèle avec le premier condensateur C1 comprenant un deuxième condensateur C2 et une première résistance R1 montée en série avec le deuxième condensateur C2.

Le filtre dérivateur FD présente une constante de temps inférieure au décuple d'une période maximale $T_{AC}$ de la partie alternative du courant destiné à circuler dans l'inductance L. Autrement dit, la constante de temps du filtre dérivateur est inférieure au décuple de la période maximale $T_{AC}$ du courant destiné à circuler dans l'inductance L.

La constante de temps TF du filtre dérivateur FD est donnée par :

$$TF = r1 * c2.$$

Où r1 est la valeur de la première résistance R1 et c2 est la capacité du deuxième condensateur C2.

Le dispositif de mesure DM comprend en outre une deuxième résistance R2 de valeur r2 montée en parallèle avec le deuxième condensateur C2 de sorte que la première résistance R1 et la deuxième résistance R2 forment un diviseur de tension.

Le filtre dérivateur FD permet d'obtenir, en sortie du filtre dérivateur FD, une tension qui est une image d'une dérivée de la tension appliquée aux bornes du filtre dérivateur FD qui est la tension appliquée aux bornes du premier condensateur. Cette tension est donc l'image du courant $I_{DM}$ circulant dans le premier condensateur C1.

Le diviseur de tension permet de diviser la tension appliquée en entrée du premier condensateur C1 qui est la tension d'entrée du dispositif de mesure DM.

Ainsi la tension $V_{mes}$ délivrée en sortie du dispositif de mesure DM, c'est à dire la tension aux bornes de la première résistance R1, est une somme pondérée d'une tension image du courant $I_{DM}$ d'alimentation du dispositif de mesure DM, c'est-à-dire du courant circulant dans le premier condensateur C1 (cette tension image est obtenue par le filtre dérivateur) et de la tension appliquée aux bornes du dispositif de mesure $V_z$, c'est-à-dire de la tension appliquée aux bornes du premier condensateur C1 (obtenue par le diviseur de tension).

La totalité des variations du courant $I_{LOAD}$ circule dans le condensateur C1. Par conséquent, en dérivant la tension aux bornes du condensateur on obtient une image des variations du courant circulant dans $I_{LOAD}$.

La tension $V_{mes}$ mesurée aux bornes de la première résistance R1 est donc donnée par :

$$V_{mes} = \frac{r1 * c2}{c1} * I_{DM} + \frac{r1}{r1 + r2} * V_z$$

Où $V_z$ qui est la tension appliquée aux bornes d'entrée du dispositif de mesure DM est aussi la tension mesurée aux bornes de l'impédance utilisateur Z qui est, par exemple, la tension de sortie d'un onduleur de tension.

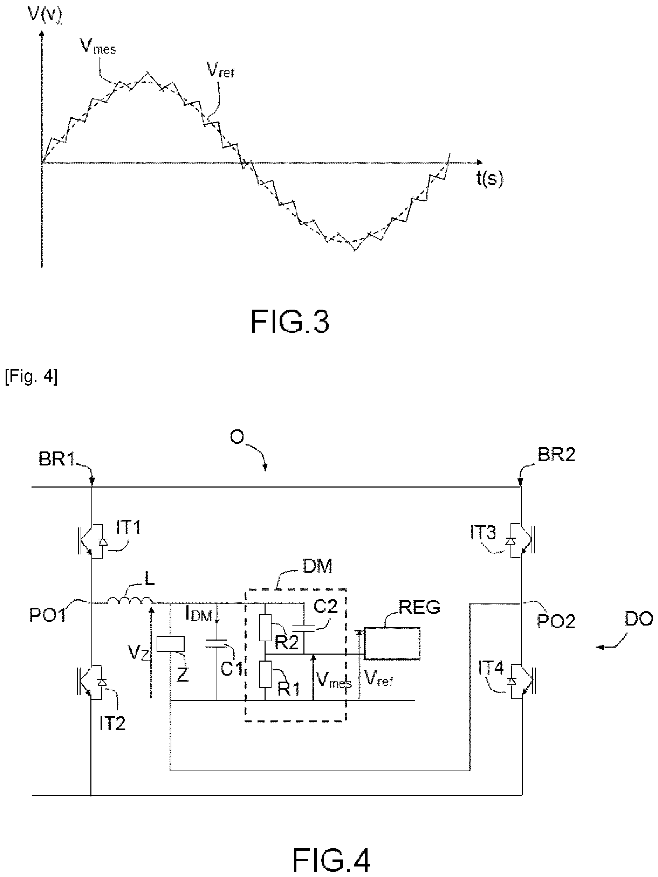

Un exemple de tension $V_{mes}$ mesurée aux bornes de la première résistance R1 est représenté en figure 3 en traits pleins, dans le cas où le dispositif de mesure est branché en sortie d'un onduleur de tension. La tension de référence souhaitée en sortie du condensateur $V_{ref}$ est une tension sinusoïdale représentée en traits pointillés. La tension $V_{mes}$ est sensiblement la superposition d'une tension sinusoïdale $V_{ref}$ et d'une tension alternative en triangle image du courant d'alimentation du premier condensateur.

Le dispositif de mesure présente l'avantage de comprendre uniquement des composants passifs. Il est simple, peu coûteux et présente une masse relativement faible. Cela permet son intégration aisée dans un dispositif onduleur, par exemple, pour assurer la régulation d'un onduleur de tension de faible ou de forte puissance.

Par ailleurs, ce dispositif de mesure DM présent l'avantage d'être dépourvu d'élément magnétique. Cela permet d'éviter les problèmes liés à la saturation du matériau magnétique, notamment la non linéarité de la mesure.

L'invention se rapporte également à un dispositif onduleur comprenant un onduleur monophasé destiné à transformer une tension continue en une tension monophasée.

Un exemple d'un tel dispositif onduleur DO selon l'invention est représenté en figure 4.

L'onduleur O comprend quatre interrupteurs de puissance commandables IT1, IT2, IT3, IT4 montés en pont en H. Le pont en H comprend deux branches BR1 et BR2 comprenant chacune deux interrupteurs connectés en série. La première branche BR1 comprend un premier interrupteur IT1 et un deuxième interrupteur IT2 reliés en série par l'intermédiaire d'un premier point PO1 dit premier point milieu. La deuxième branche BR2 comprend un troisième interrupteur IT3 et un quatrième interrupteur IT4 reliés en série par l'intermédiaire d'un deuxième point PO2 dit deuxième point milieu.

L'onduleur O comprend également un filtre passe-bas de sortie formé par le premier condensateur C1 et de l'inductance L. Les onduleurs de tension comprennent habituellement ce type de filtre passe-bas.

Le premier condensateur C1 permet d'éliminer la composante continue de la tension et l'inductance L permet de contrôler le niveau et les variations du courant $I_{LOAD}$ circulant dans la ligne comprenant l'inductance.

Le premier point milieu PO1 est relié à une première borne du premier condensateur C1 via l'inductance L et le deuxième point milieu PO2 est relié à une deuxième borne du premier condensateur C1.

La période $T_{AC}$ citée plus haut est la période de commutation des interrupteurs. La période de la partie alternative du courant circulant dans l'inductance L est égale à la période de commutation des interrupteurs.

La tension de sortie de l'onduleur O est la tension aux bornes du premier condensateur C1.

L'impédance utilisateur Z est montée en parallèle avec le premier condensateur C1.

Le dispositif onduleur DO comprend également un dispositif de mesure DM tel que représenté en figure 2.

Le dispositif de mesure DM selon l'invention présente l'avantage de se servir du premier condensateur C1 habituellement présent dans les onduleurs de tension, pour délivrer la mesure souhaité.

En variante, le dispositif de mesure DM comprend le premier condensateur C1.

Cela permet de se servir du dispositif de mesure DM selon l'invention sur un onduleur de courant habituellement dépourvu d'un tel condensateur C1 de sortie.

Avantageusement, le dispositif onduleur DO comprend un régulateur REG configuré pour commander les interrupteurs de puissance IT1 à IT4 à partir de la tension $V_{mes}$ aux bornes de la première résistance R1 et d'une tension sinusoïdale de référence $V_{ref}$.

La tension de référence $V_{ref}$ est, par exemple, la tension d'alimentation de l'impédance utilisateur souhaitée.

Le régulateur REG est avantageusement configuré pour commander les interrupteurs de puissance IT1 à IT4 à partir de la tension aux bornes de la première résistance $V_{mes}$ et de la tension sinusoïdale de référence $V_{ref}$ de façon que la tension d'alimentation du dispositif de mesure DM ou tension d'alimentation de l'impédance utilisateur Z soit sensiblement égale à la tension de référence $V_{ref}$.

Le régulateur REG est avantageusement configuré pour commander les interrupteurs commandables par modulation de largeur d'impulsions (MLI ou PWM pour "Pulse Width Modulation"), par exemple à hystérésis ou tout autre type de commande par MLI.

Le régulateur REG est configuré pour délivrer des commandes faisant commuter les interrupteurs à une fréquence de découpage Fd avec un rapport cyclique Rc définis à partir de la tension $V_{mes}$ et de la tension de référence $V_{ref}$.

Le dispositif onduleur peut comprendre plusieurs onduleurs monophasés tels que représentés en figure 4, montés en parallèle, chacun étant associé à un dispositif de mesure selon l'invention et à un dispositif de commande. Les différents onduleurs sont associés à des dispositifs de mesure distincts et à des dispositifs de commande distincts.

Les dispositifs de commande sont avantageusement configurés pour commander les interrupteurs électroniques commandables des onduleurs de sorte que chaque onduleur délivre une des phases d'une tension alternative triphasée de fréquence fixe et que les trois onduleurs délivrent les trois phases de la tension triphasée. Ce type de commande est classique pour l'homme du métier.

Le dispositif de commande est, par exemple, configuré pour que chaque onduleur fournisse une tension alternative à 400Hz de tension efficace de 300 V, les trois tensions alternatives étant déphasées de sorte à former les phases d'une tension alternative triphasée, à partir d'une tension continue de 540 V.

Cette configuration permet d'offrir une disponibilité partielle du dispositif onduleur DO en cas de panne d'un des onduleurs.

Le régulateur peut comprendre un ou plusieurs circuits électroniques dédiés ou un circuit à usage général.

Chaque circuit électronique peut comprendre Le régulateur REG comprend avantageusement des moyens analogiques, comme par exemple au moins un comparateur et/ou au moins un amplificateur et/ou au moins une porte logique.

En variante, le régulateur comprend une machine de calcul reprogrammable (un processeur ou un microcontrôleur par exemple) et/ ou un calculateur exécutant un programme comprenant une séquence d'instructions et/ou une machine de calcul dédiée (par exemple un ensemble de portes logiques comme un FPGA, un DSP ou un ASIC, ou tout autre module matériel) et/ou des composants analogiques.

Le régulateur REG comprend, par exemple, un ou plusieurs dispositifs d'attaque (ou « drivers ») pour commander les commutations successives de chacun des interrupteurs.

## Revendications

1. Dispositif onduleur (DO) destiné à transformer une tension continue en une tension monophasée, le dispositif onduleur (DO) comprenant un filtre passe bas, un dispositif de mesure (DM), et quatre interrupteurs de puissance montés en pont en H, le dit filtre passe bas comprenant un premier condensateur (C1) et une inductance (L), le dit dispositif de mesure (DM) configuré pour délivrer une tension correspondant à une superposition d'une tension d'entrée appliquée aux bornes du dispositif de mesure (DM) et d'une tension image d'un courant circulant dans le premier condensateur (C1) aux bornes duquel est appliquée la tension d'entrée, le dispositif de mesure (DM) comprenant :

    - un filtre dérivateur (FD) monté en parallèle avec le premier condensateur (C1) et comprenant un deuxième condensateur (C2) et une première résistance (R1) montée en série avec le deuxième condensateur (C2),
    - une deuxième résistance (R2) montée en parallèle avec le deuxième condensateur (C2) ;

ledit pont comprenant deux branches comprenant chacune deux interrupteurs connectés en série, un premier point milieu (PO1) reliant les deux interrupteurs d'une première des deux branches et un deuxième point milieu (PO2) reliant les deux interrupteurs d'une deuxième des deux branches, le premier point milieu (PO1) étant relié à une première borne du premier condensateur (C1) via l'inductance (L) et le deuxième point milieu (PO2) étant relié à une deuxième borne du premier condensateur (C1).

**2.** Dispositif onduleur (DO) selon la revendication 1, dans lequel le filtre dérivateur (FD) présente une constante de temps inférieure au décuple d'une période maximale prédéterminée du courant d'entrée.

**3.** Dispositif onduleur (DO) selon l'une des revendications 1 ou 2, comprenant un régulateur (REG) configuré pour commander les interrupteurs en fonction de la tension délivrée aux bornes de la première résistance (R1).

## Patentansprüche

**1.** Wechselrichtervorrichtung (DO) zum Umwandeln einer Gleichspannung in eine einphasige Spannung, wobei die Wechselrichtervorrichtung (DO) einen Tiefpassfilter, eine Messvorrichtung (DM) und vier Leistungsschalter umfasst, die in einer H-Brückenschaltung angeordnet sind, wobei der Tiefpassfilter einen ersten Kondensator (C1) und eine Induktivität (L) umfasst, wobei die Messvorrichtung (DM) so konfiguriert ist, dass sie eine Spannung liefert, die einer Überlagerung einer an die Klemmen der Messvorrichtung (DM) angelegten Eingangsspannung und einer Spannung entspricht, die ein Abbild eines Stroms ist, der in dem ersten Kondensator (C1) fließt, an dessen Klemmen die Eingangsspannung angelegt ist, wobei die Messvorrichtung (DM) Folgendes umfasst:

    - einen parallel zum ersten Kondensator (C1) geschalteten Ableitungsfilter (FD), der einen zweiten Kondensator (C2) und einen ersten Widerstand (R1) umfasst, der in Reihe mit dem zweiten Kondensator (C2) geschaltet ist,
    - einen zweiten Widerstand (R2), der parallel zu dem zweiten Kondensator (C2) geschaltet ist;

wobei die Brücke zwei Zweige umfasst, die jeweils zwei in Reihe geschaltete Schalter aufweisen, wobei ein erster Mittelpunkt (PO1) die beiden Schalter eines ersten der beiden Zweige verbindet und ein zweiter Mittelpunkt (PO2) die beiden Schalter eines zweiten der beiden Zweige verbindet, wobei der erste Mittelpunkt (PO1) über die Induktivität (L) mit einem ersten Anschluss des ersten Kondensators (C1) verbunden ist und der zweite Mittelpunkt (PO2) mit einem zweiten Anschluss des ersten Kondensators (C1) verbunden ist.

**2.** Wechselrichtervorrichtung (DO) nach Anspruch 1, wobei der Ableitungsfilter (FD) eine Zeitkonstante aufweist, die kleiner als das Zehnfache einer vorbestimmten maximalen Periode des Eingangsstroms ist.

**3.** Wechselrichtervorrichtung (DO) nach einem der Ansprüche 1 oder 2, umfassend einen Regler (REG), der so konfiguriert ist, dass er die Schalter in Abhängigkeit von der an die Anschlüsse des ersten Widerstands (R1) gelieferten Spannung steuert.

## Claims

**1.** An inverter device (DO) intended to convert a DC voltage into a single-phase voltage, the inverter device (DO) comprising a low-pass filter, a measurement device (DM), and four H-bridge power switches, said low-pass filter comprising a first capacitor (C1) and an inductance (L), said measurement device (DM) being configured to deliver a voltage corresponding to the superimposition of an input voltage applied to the terminals of the measurement device (DM) and to a voltage reflecting a current flowing in the first capacitor (C1), at the terminals of which the input voltage is applied, the measurement device (DM) comprising:

    - a by-pass filter (FD) mounted parallel to the first capacitor (C1) and comprising a second capacitor (C2) and a first resistor (R1) mounted in series with the second capacitor (C2);
    - a second resistor (R2) mounted parallel to the second capacitor (C2);

said bridge comprising two branches each comprising two switches connected in series, a first centre tap (PO1) connecting the two switches of a first one of the two branches and a second centre tap (PO2) connecting the two switches of a second one of the two branches, with the first centre tap (PO1) being connected to a first terminal of the first capacitor (C1) via the inductance (L) and the second centre tap (PO2) being connected to a second terminal of the first capacitor (C1).

2. The inverter device (DO) according to claim 1, wherein the by-pass filter (FD) has a time constant that is less than ten times a predetermined maximum period of the input current.

3. The inverter device (DO) according to any of claims 1 or 2, comprising a regulator (REG) configured to control the switches as a function of the voltage delivered to the terminals of the first resistor (R1).

[Fig. 1]

FIG.1

[Fig. 2]

FIG.2

[Fig. 3]

FIG.3

[Fig. 4]

FIG.4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012068548 A1
- US 2009243431 A1